# EUROPEAN PATENT APPLICATION

(11) **EP 4 835 502 A1**
(43) Date of publication of application: **04.11.2026**
(21) Application number: 25902715.9
(22) Date of filing: 10.06.2025
(51) Int. Cl.: G01R 31/385, G01R 27/02

(54) **BATTERY CELL PERFORMANCE PARAMETER PREDICTION METHOD AND APPARATUS, AND ELECTRONIC DEVICE**

(30) Priority: 13.12.2024 CN 202411843309
(71) Applicant: Shanghai Xuanyi New Energy Development Co., Ltd, Shanghai 201806 (CN)
(72) Inventor: HE, Yan, Shanghai 201806 (CN); CHEN, Yihong, Shanghai 201806 (CN); ZHANG, Ya, Shanghai 201806 (CN); JIANG, Taizhi, Shanghai 201806 (CN)
(74) Representative: Studio Torta S.p.A.
(86) International application number: PCT/CN2025/100217
(87) International publication number: WO 2026/123621

(57) **Abstract**

The present disclosure discloses a method and apparatus for predicting performance parameters of a cell, and an electronic device. The method includes: acquiring a target slurry, where the target slurry is configured to construct a target type of cell; determining test data corresponding to the target slurry under test parameters, where the test data includes impedance test data; inputting the impedance test data into an equivalent circuit model for fitting to obtain a plurality of circuit parameter values, where the equivalent circuit model is constructed based on the target type of cell; and predicting, based on the plurality of circuit parameter values, performance parameters of the cell fabricated using the target slurry under the test parameters. The present disclosure solves a technical problem in the related art where it is difficult to conveniently determine cell-related performance parameters from the slurry.

## Description

This application claims priority to Chinese Patent Application No. 202411843309.7, filed with the China National Intellectual Property Administration on December 13, 2024, and entitled "Method and apparatus for predicting performance parameters of cell, and electronic device", which is incorporated herein by reference in its entirety.

### Technical Field

The present disclosure relates to the battery field, and specifically, to a method and apparatus for predicting performance parameters of a cell, and an electronic device.

### Background

A lithium-ion battery is formed by a positive electrode, a negative electrode, and an electrolyte, and the conductive performance of an electrode slurry is an important indicator for evaluating electrode performance. The conductivity refers to the capability of an object to conduct current. The conductivity of materials in each part of the battery is directly related to the battery capacity utilization and rate performance.

Generally, the conductive performance of the electrode slurry is evaluated by adopting a method for measuring the conductivity of the slurry. Currently, for the resistivity testing of a conductive slurry of a battery material, the Chinese published patent CN108303592A discloses a method for testing conductivity of a coating layer on a lithium-ion battery electrode plate, and the Chinese published patent CN108226641A discloses a method for testing conductivity of a positive electrode material for a lithium-ion battery. However, an internal composition of the conductive slurry for a lithium-ion battery electrode is complex. The foregoing conventional methods cannot quickly acquire internal conductive network data, making it impossible to determine the composition of an internal conductive network of the slurry, and further hindering the screening of conductive agent types and contents as well as main material types and contents. As a result, the screening of electrode slurry formulations is cumbersome and inefficient, bringing a technical problem that it is difficult to conveniently determine cell-related performance parameters from the slurry.

Currently, no effective solutions have been proposed for the foregoing problems.

### Summary

Embodiments of the present disclosure provide a method and apparatus for predicting performance parameters of a cell, and an electronic device, to at least solve a technical problem in the related art where it is difficult to conveniently determine cell-related performance parameters from the slurry.

According to one aspect of embodiments of the present disclosure, a method for predicting performance parameters of a cell is provided, and the method includes: acquiring a target slurry, where the target slurry is configured to construct a target type of cell; determining test data corresponding to the target slurry under test parameters, where the test data includes impedance test data; inputting the impedance test data into an equivalent circuit model for fitting to obtain a plurality of circuit parameter values, where the equivalent circuit model is constructed based on the target type of cell, the equivalent circuit model includes four sub-circuits, a first sub-circuit includes a charge transfer resistance, a second sub-circuit is formed by a solution resistance connected in parallel with a first constant phase element, a third sub-circuit is formed by an active material resistance connected in parallel with a second constant phase element, a fourth sub-circuit is formed by a double layer resistance-capacitance connected in parallel with a third constant phase element, the first constant phase element is a constant phase element representing interfacial characteristics between a binder and a solvent, the second constant phase element is a constant phase element representing interfacial characteristics between the binder and an active material, the third constant phase element is a constant phase element representing interfacial characteristics between a conductive agent and the active material, the double layer resistance-capacitance is obtained by connecting a double layer resistance and a double layer capacitance in series, and the four sub-circuits are connected in series sequentially; and predicting, based on the plurality of circuit parameter values, performance parameters of the cell fabricated using the target slurry under the test parameters.

As at least one alternative embodiment, the predicting, based on the plurality of circuit parameter values, performance parameters of the cell fabricated using the target slurry under the test parameters includes: determining charge transfer efficiency performance between the solvent and an electrode material based on a fitted charge transfer resistance value in a case where the target slurry includes the electrode material, a conductive agent, and the solvent, the electrode material includes an active material, and the plurality of circuit parameter values include a fitted charge transfer resistance value, a fitted solution resistance value, a fitted active material resistance value, a fitted double layer resistance value, and a fitted constant phase element value; determining, based on the fitted solution resistance value, a conductive path impedance formed by the binder and a conductive material; determining, based on the fitted active material resistance value, an active material impedance of the active material within the electrode material; determining, based on the fitted double layer resistance value, charge transport performance between the conductive agent and the active material; determining, based on the fitted constant phase element value, dispersion performance of each component within the target slurry; and predicting the performance parameters of the cell fabricated using the target slurry under the test parameters based on the charge transfer efficiency performance, the conductive path impedance, the active material impedance, the charge transport performance, and the dispersion performance.

As at least one alternative embodiment, the predicting the performance parameters of the cell fabricated using the target slurry under the test parameters based on the charge transfer efficiency performance, the conductive path impedance, the active material impedance, the charge transport performance, and the dispersion performance includes: determining first sub-contact performance between the binder and the solvent based on a first constant phase element value in a case where the electrode material further includes the binder, and the fitted constant phase element value includes a first constant phase element value, a second constant phase element value, and a third constant phase element value; determining second sub-contact performance between the binder and the active material based on the second constant phase element value; determining third sub-contact performance between the conductive agent and the active material based on the third constant phase element value; determining contact performance corresponding to the electrode material based on the first sub-contact performance, the second sub-contact performance, and the third sub-contact performance; and predicting the performance parameters of the cell fabricated using the target slurry under the test parameters based on the charge transfer efficiency performance, the conductive path impedance, the active material impedance, the charge transport performance, the dispersion performance, and the contact performance.

As at least one alternative embodiment, the determining test data corresponding to the target slurry under test parameters includes: transferring the target slurry into a predetermined test fixture, where the predetermined test fixture includes a target test tube, a first conductive electrode, and a second conductive electrode, the first conductive electrode is located on a first side surface of the target test tube, and the second conductive electrode is located on a second side surface of the target test tube; and activating the predetermined test fixture under the test parameters to obtain the test data.

As at least one alternative embodiment, a frequency band of an alternating current test current corresponding to the second sub-circuit is greater than a frequency band of an alternating current test current corresponding to the third sub-circuit, and the frequency band of the alternating current test current corresponding to the third sub-circuit is greater than a frequency band of an alternating current test current corresponding to the fourth sub-circuit.

As at least one alternative embodiment, after the predicting, based on the plurality of circuit parameter values, performance parameters of the cell fabricated using the target slurry under the test parameters, the method further includes: determining composition parameters of the target slurry in a case where the performance parameters are less than a predetermined threshold; and adjusting the composition parameters to obtain an updated slurry, so as to determine performance parameters corresponding to the updated slurry.

As at least one alternative embodiment, before the inputting the impedance test data into an equivalent circuit model for fitting to obtain a plurality of circuit parameter values, the method further includes: acquiring a sample slurry and a sample battery constructed from the sample slurry, where the sample battery is the target type of battery; determining sample performance parameters of the sample battery; determining a correlation between a composition of the sample slurry and the sample performance parameters; and constructing the equivalent circuit model based on the correlation.

According to one aspect of the embodiments of the present disclosure, an apparatus for predicting performance parameters of a cell is provided. The apparatus includes: an acquiring module, configured to acquire a target slurry, where the target slurry is configured to construct a target type of cell; a determination module, configured to determine test data corresponding to the target slurry under test parameters, where the test data includes impedance test data; a fitting module, configured to input the impedance test data into an equivalent circuit model for fitting to obtain a plurality of circuit parameter values, where the equivalent circuit model is constructed based on the target type of cell, the equivalent circuit model includes four sub-circuits, a first sub-circuit includes a charge transfer resistance, a second sub-circuit is formed by a solution resistance connected in parallel with a first constant phase element, a third sub-circuit is formed by an active material resistance connected in parallel with a second constant phase element, a fourth sub-circuit is formed by a double layer resistance-capacitance connected in parallel with a third constant phase element, the first constant phase element is a constant phase element representing interfacial characteristics between a binder and a solvent, the second constant phase element is a constant phase element representing interfacial characteristics between the binder and an active material, the third constant phase element is a constant phase element representing interfacial characteristics between a conductive agent and the active material, the double layer resistance-capacitance is obtained by connecting a double layer resistance and a double layer capacitance in series, and the four sub-circuits are connected in series sequentially; and a prediction module, configured to predict, based on the plurality of circuit parameter values, performance parameters of the cell fabricated using the target slurry under the test parameters.

According to one aspect of the embodiments of the present disclosure, an electronic device is provided, and includes a processor; and a memory configured to store instructions executable by the processor, where the processor is configured to execute the instructions, to implement any one of the foregoing methods for predicting performance parameters of the cell.

According to one aspect of the embodiments of the present disclosure, a computer-readable storage medium is provided. Instructions in the computer-readable storage medium, when executed by a processor of an electronic device, cause the electronic device to perform any one of the foregoing methods for predicting performance parameters of the cell.

In the embodiments of the present disclosure, the target slurry is acquired, where the target slurry is configured to construct the target type of cell. The test data corresponding to the target slurry under the test parameters is determined, where the test data includes the impedance test data. The impedance test data is inputted into the equivalent circuit model for fitting to obtain the plurality of circuit parameter values, where the equivalent circuit model is constructed based on the target type of cell. The equivalent circuit model includes the four sub-circuits. The first sub-circuit includes the charge transfer resistance, the second sub-circuit is formed by the solution resistance connected in parallel with the first constant phase element, the third sub-circuit is formed by the active material resistance connected in parallel with the second constant phase element, and the fourth sub-circuit is formed by the double layer resistance-capacitance connected in parallel with the third constant phase element. The first constant phase element is the constant phase element representing the interfacial characteristics between the binder and the solvent. The second constant phase element is the constant phase element representing the interfacial characteristics between the binder and the active material. The third constant phase element is the constant phase element representing the interfacial characteristics between the conductive agent and the active material. The double layer resistance-capacitance is obtained by connecting the double layer resistance and the double layer capacitance in series. The four sub-circuits are connected in series sequentially. Based on the plurality of circuit parameter values, the performance parameters of the cell fabricated using the target slurry under the test parameters are predicted. By determining the test data corresponding to the target slurry under the test parameters and inputting the impedance test data into the equivalent circuit model for fitting, the plurality of circuit parameter values are obtained. By fitting the circuit parameter values, the performance parameters of the cell are predicted, thereby solving the technical problem in the related art where it is difficult to conveniently determine cell-related performance parameters from the slurry.

### Brief Description of the Drawings

The accompanying drawings illustrated herein are used for providing a further understanding of the present disclosure and form a part of this application. Exemplary embodiments of the present disclosure and descriptions thereof are used for explaining the present disclosure, and do not form improper limitations on the present disclosure. In the accompanying drawings:
Fig. 1 is a flowchart of a method for predicting performance parameters of a cell according to an embodiment of the present disclosure.
Fig. 2 is a schematic diagram of a test fixture according to an optional implementation of the present disclosure.
Fig. 3 is a schematic diagram of an internal slurry impedance fitting circuit according to an optional implementation of the present disclosure.
Fig. 4 is a comparison diagram of slurry impedance data under different conductive agent contents according to an optional implementation of the present disclosure.
Fig. 5 illustrates fitting data of an internal impedance of a slurry according to an optional implementation of the present disclosure.
Fig. 6 is a structural block diagram of an apparatus for predicting cell performance parameters according to an embodiment of the present disclosure.

### Detailed Description of the Embodiments

In order to make those skilled in the art better understand solutions of the present disclosure, the technical solutions in the embodiments of the present disclosure are clearly and completely described with reference to the accompanying drawings in the embodiments of the present disclosure as below, and it is apparent that the described embodiments are merely a part rather all embodiments of the present disclosure. Based on the embodiments of the present disclosure, all other embodiments obtained by those of ordinary skill in art without creative work shall fall within the scope of protection of the present disclosure.

It should be noted that the terms such as "first" and "second" of the specification and claims of the present disclosure, as well as the foregoing accompanying drawings are used to distinguish similar objects but are not necessarily intended to describe specific sequences or precedence orders. It should be understood that such used data is interchangeable where appropriate, such that the embodiments of the present disclosure described herein may be implemented in sequences other than those illustrated or described herein. In addition, the terms "include", "have", and any variations thereof are intended to encompass non-exclusive inclusions. For example, a process, a method, a system, a product, or a device including a series of steps or units is not necessarily limited to those explicitly-listed steps or units, but may include other steps or units that are not explicitly listed or inherent to the process, the method, the system, the product, or the device.

### Embodiment 1

According to this embodiment of the present disclosure, an embodiment of a method for predicting performance parameters of a cell is provided. It should be noted that steps shown in flowcharts of the accompanying drawings may be performed in a computer system, such as a set of computer-executable instructions. Although a logical sequence is shown in the flowcharts, the steps shown or described may be performed in a sequence different from that shown herein in some cases.

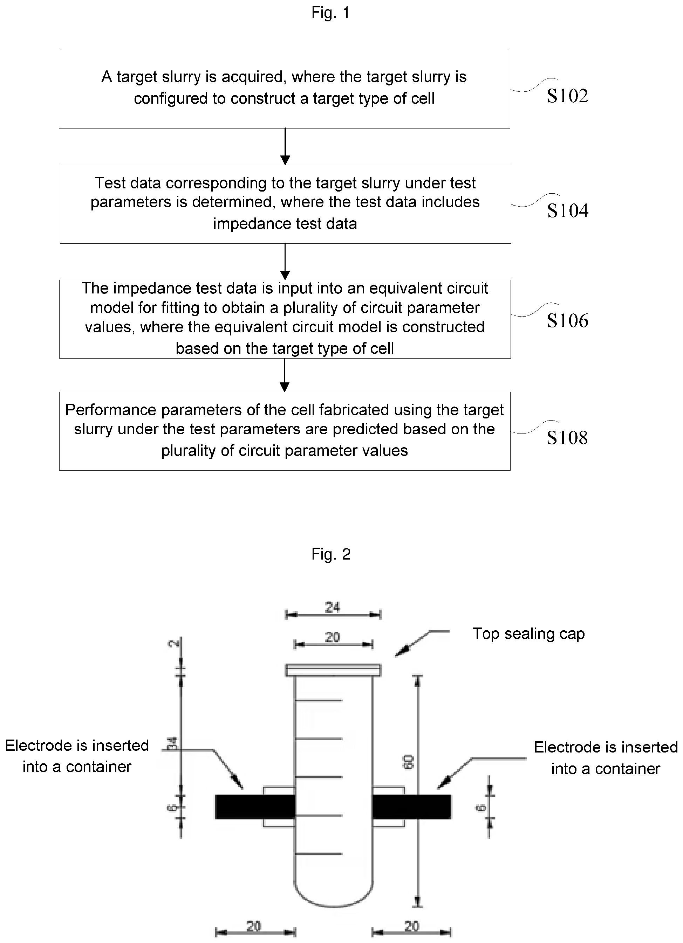

Fig. 1 is a flowchart of a method for predicting performance parameters of a cell according to an embodiment of the present disclosure. As shown in Fig. 1, the method includes the following steps:
Step S102: A target slurry is acquired, where the target slurry is configured to construct a target type of cell.

In step S102 provided in this application, the target slurry configured to construct the target type of cell is acquired.

The target slurry is involved herein. In lithium-ion battery manufacturing, an electrode slurry is a fluid material prepared by mixing an electrode active material (a main material, e.g., lithium cobalt oxide, or lithium iron phosphate), a conductive agent, a binder, and other components with a solvent. The target slurry refers to an electrode slurry elaborately formulated according to specific battery performance requirements or design standards. A formulation, component ratios, a preparation process, etc. of such slurry are all optimized to meet specific performance indicators of the target cell, such as improving energy density, enhancing cycle stability, and increasing power output.

The target type of cell is involved herein. This type of cell refers to a battery unit designed for a specific application scenario with specific performance parameters, such as a high-energy-density cell for electric vehicles, or a high-cycle-life cell for energy storage systems.

Acquiring the target slurry means that a slurry formulation has already been designed. This slurry is used to construct the target type of cell. That is, through a series of manufacturing processes, the slurry is converted into the battery unit that meets the design standards.

Step S104: Test data corresponding to the target slurry under test parameters is determined, where the test data includes impedance test data.

In step S104 provided by this application, the test data corresponding to the target slurry under the test parameters is determined.

The test parameters are involved herein. The test parameters refer to conditions set during a testing process, including but not limited to a temperature, a frequency, a disturbance voltage, a test environment, etc. In electrochemical impedance testing, these parameters are critical to the accuracy and reliability of results. For example, a range of test frequency may affect the detection sensitivity to different parts of a slurry impedance (e.g., a charge transfer resistance and a diffusion resistance).

The test data is involved herein. The test data refers to a result obtained through experimental measurements, including key information about the performance of the target slurry. In this application, the test data mainly refers to the impedance test data, including information such as a resistance (R), a capacitance (C), an inductance (L), or an impedance phase angle.

In this step, determining the test data corresponding to the target slurry under the test parameters means that after specific test conditions (e.g., temperature and frequency range) are set, impedance testing is performed on the target slurry, and the impedance test data is collected and recorded. The data reflects electrochemical characteristics of the slurry under given conditions, including the integrity of the internal conductive network, a charge transport resistance within the slurry, and an interaction between the slurry and a test electrode.

Step S106: The impedance test data is input into an equivalent circuit model for fitting to obtain a plurality of circuit parameter values, where the equivalent circuit model is constructed based on the target type of cell. The equivalent circuit model includes four sub-circuits. A first sub-circuit includes a charge transfer resistance, a second sub-circuit is formed by a solution resistance connected in parallel with a first constant phase element, a third sub-circuit is formed by an active material resistance connected in parallel with a second constant phase element, and a fourth sub-circuit is formed by a double layer resistance-capacitance connected in parallel with a third constant phase element. The first constant phase element is a constant phase element representing interfacial characteristics between a binder and a solvent. The second constant phase element is a constant phase element representing interfacial characteristics between the binder and an active material. The third constant phase element is a constant phase element representing interfacial characteristics between a conductive agent and the active material. The double layer resistance-capacitance is obtained by connecting a double layer resistance and a double layer capacitance in series. The four sub-circuits are connected in series sequentially.

In step S106 provided by this application, the impedance test data is inputted into the equivalent circuit model for fitting, thereby obtaining the plurality of circuit parameter values.

The equivalent circuit model is involved herein. In electrochemical impedance spectroscopy (EIS) analysis, the equivalent circuit model is a method for simulating impedance characteristics of an electrochemical cell or slurry using electronic circuit elements (e.g., a resistor, a capacitor, and an inductor). By adjusting parameters of the elements in the model, an output impedance of the model is made to match an actually measured impedance.

The charge transfer resistance is involved herein, which represents a resistance encountered when charges move within the electrode slurry, and is usually related to the dispersion of the conductive agent and the active material.

The solution resistance is involved herein. Inside the battery, ion migration in an electrolyte also encounters the resistance, and this portion of resistance is referred to as the solution resistance. The solution resistance is usually related to a type and concentration of the electrolyte, as well as an operating temperature of the battery.

The first/second/third constant phase element is involved. The constant phase element is an element configured to simulate a behavior of a non-ideal capacitor or a parallel combination of a capacitor and a resistor. In the equivalent circuit model for the battery slurry, the first constant phase element simulates the interfacial characteristics between the binder and the solvent, the second constant phase element simulates the interfacial characteristics between the binder and the active material, and the third constant phase element simulates the interfacial characteristics between the conductive agent and the active material.

The double layer resistance-capacitance is involved. A double layer refers to an electrochemical layer formed between an electrode surface and an electrolyte interface, which is composed of tightly adsorbed charges and counter-charges, forming a capacitor. The double layer resistance-capacitance (part of a Randles circuit) includes a combination of a double layer resistance (Rdl) and a double layer capacitance (Cdl), for simulating an electrochemical behavior at the electrode/electrolyte interface.

The plurality of circuit parameter values are involved. In electrochemical impedance spectroscopy (EIS) analysis, a series of circuit parameter values are obtained after fitting the impedance test data with the equivalent circuit model, including, for example, a charge transfer resistance (Rct), a solution resistance (Rs), an active material resistance (Ractive), a double layer resistance (Rdl), and constant phase element (CPE) parameters. These parameter values respectively reflect electrochemical processes such as internal charge transport in the electrode slurry, solution conductivity, electrochemical reactions of the active material, and material interfacial characteristics.

By inputting the impedance test data into the equivalent circuit model for fitting, the plurality of circuit parameter values may be acquired. The parameter values acquired during the fitting process can reveal interactions among components in the slurry, as well as how the components affect the conductive performance and electrochemical stability of the electrode. In addition, the analysis based on the equivalent circuit model may guide the selection of battery materials and the optimization of the slurry formulation, so as to improve battery efficiency and reliability.

Step S108: Performance parameters of the cell fabricated using the target slurry under the test parameters are predicted based on the plurality of circuit parameter values.

In step S108 provided in this application, the performance parameters of the cell fabricated using the target slurry under the test parameters are predicted based on the plurality of circuit parameter values.

The performance parameters of the cell are involved. The cell is a basic unit of the battery, with the performance parameters including an energy density, a power density, a cycle life, an impedance, charge/discharge efficiency, temperature stability, safety, and the like. These parameters directly determine the overall performance and application scope of the battery.

In this step, by inputting the obtained plurality of circuit parameter values into the equivalent circuit model based on target slurry characteristics, the performance parameters of the cell fabricated using the slurry under the set test parameters may be predicted. Based on the analysis of the circuit parameter values, more suitable slurry components and ratios may be screened, such as selecting more efficient conductive agents, or optimizing the types and content of active materials, so as to achieve ideal cell performance.

Through the foregoing steps S102 to S108, the target slurry is acquired, where the target slurry is configured to construct the target type of cell. The test data corresponding to the target slurry under the test parameters is determined, where the test data includes the impedance test data. The impedance test data is inputted into the equivalent circuit model for fitting to obtain the plurality of circuit parameter values, where the equivalent circuit model is constructed based on the target type of cell. The equivalent circuit model includes the four sub-circuits. The first sub-circuit includes the charge transfer resistance, the second sub-circuit is formed by the solution resistance connected in parallel with the first constant phase element, the third sub-circuit is formed by the active material resistance connected in parallel with the second constant phase element, and the fourth sub-circuit is formed by the double layer resistance-capacitance connected in parallel with the third constant phase element. The first constant phase element is the constant phase element representing the interfacial characteristics between the binder and the solvent. The second constant phase element is the constant phase element representing the interfacial characteristics between the binder and the active material. The third constant phase element is the constant phase element representing the interfacial characteristics between the conductive agent and the active material. The double layer resistance-capacitance is obtained by connecting the double layer resistance and the double layer capacitance in series. The four sub-circuits are connected in series sequentially. Based on the plurality of circuit parameter values, the performance parameters of the cell fabricated using the target slurry under the test parameters are predicted. By determining the test data corresponding to the target slurry under the test parameters and inputting the impedance test data into the equivalent circuit model for fitting, the plurality of circuit parameter values are obtained. By fitting the circuit parameter values, the performance parameters of the cell are predicted, thereby solving the technical problem in the related art where it is difficult to conveniently determine cell-related performance parameters from the slurry.

As an optional embodiment, the step of predicting, based on the plurality of circuit parameter values, performance parameters of the cell fabricated using the target slurry under the test parameters includes: determining charge transfer efficiency performance between the solvent and an electrode material based on a fitted charge transfer resistance value Rs in a case where the target slurry includes the electrode material, a conductive agent, and the solvent, the electrode material includes an active material, and the plurality of circuit parameter values include a fitted charge transfer resistance value Rs, a fitted solution resistance value Rso, a fitted active material resistance value Rp, a fitted double layer resistance value Rdl, and a fitted constant phase element (CPE) value; determining, based on the fitted solution resistance value Rso, a conductive path impedance formed by the binder and a conductive material; determining, based on the fitted active material resistance value Rp, an active material impedance of the active material within the electrode material; determining, based on the fitted double layer resistance value Rdl, charge transport performance between the conductive agent and the active material; determining, based on the fitted constant phase element (CPE) value, dispersion performance of each component within the target slurry; and predicting the performance parameters of the cell fabricated using the target slurry under the test parameters based on the charge transfer efficiency performance, the conductive path impedance, the active material impedance, the charge transport performance, and the dispersion performance.

In this embodiment, the step of predicting the performance parameters of the cell fabricated using the target slurry under the test parameters is described.

The electrode material is involved. The electrode material includes the active material and the conductive agent. The active material is responsible for energy storage and conversion in the battery, while the conductive agent improves the electron transport efficiency within the electrode.

The conductive agent is involved, such as a carbon nanotube, graphene, or conductive carbon black, for enhancing the electronic conductivity within the electrode and between the electrode and a current collector.

The solvent is involved: a liquid medium configured to electrode slurry preparation, such as N-methylpyrrolidone, water, or ethanol, with an appropriate solvent selected according to different battery types.

The fitted charge transfer resistance value Rs is involved, which reflects a charge movement resistance within the electrode material and at interfaces, and is directly related to the charge transfer efficiency of the battery.

The fitted solution resistance value Rso is involved, which represents an ion migration resistance in the electrolyte and determines the conductive path impedance formed by the binder and the conductive material.

The fitted active material resistance value Rp is involved, which represents the charge transport resistance of the active material itself and may be used to determine the active material impedance of the active material within the electrode material.

The fitted double layer resistance value Rdl is involved, which simulates a charge resistance at a contact interface between the conductive agent and the active material, and evaluates the charge transport performance.

The fitted constant phase element (CPE) value is involved, which is used to describe a behavior of a non-ideal capacitor or a parallel combination of a capacitor and a resistor, reflecting the dispersion performance between materials, including the dispersion performance between the binder and the active material, between the solvent and the active material, or between other interfaces.

When the target slurry includes the electrode material, the conductive agent, and the solvent, and the equivalent circuit model successfully fits to obtain the values of charge transfer resistance Rs, solution resistance Rso, active material resistance Rp, double layer resistance Rdl, and constant phase element (CPE), these parameters may respectively correspond to different electrochemical processes within the electrode slurry. By analyzing these circuit parameters, the electrochemical behavior within the slurry can be deeply understood, and further, the performance parameters of the cell fabricated using the target slurry under the set test parameters (e.g., temperature and frequency range) can be predicted, such as an energy density, a power density, a cycle life, and impedance characteristics. Through parameter analysis, the slurry formulation may be optimized in a targeted manner, such as adjusting the type and content of the conductive agent, so as to improve the electrochemical performance of the battery.

As an optional embodiment, the predicting the performance parameters of the cell fabricated using the target slurry under the test parameters based on the charge transfer efficiency performance, the conductive path impedance, the active material impedance, the charge transport performance, and the dispersion performance includes: determining first sub-contact performance between the binder and the solvent based on a first constant phase element value (CPEs) in a case where the electrode material further includes the binder, and the fitted constant phase element value includes the first constant phase element value, a second constant phase element value, and a third constant phase element value; determining second sub-contact performance between the binder and the active material based on the second constant phase element value (CPEp); determining third sub-contact performance between the conductive agent and the active material based on the third constant phase element value (CPEdl); determining contact performance corresponding to the electrode material based on the first sub-contact performance, the second sub-contact performance, and the third sub-contact performance; and predicting the performance parameters of the cell fabricated using the target slurry under the test parameters based on the charge transfer efficiency performance, the conductive path impedance, the active material impedance, the charge transport performance, the dispersion performance, and the contact performance.

In this embodiment, the step of determining the contact performance to determine the performance parameters is described.

The constant phase element (CPE) value is involved. In electrochemical impedance spectroscopy analysis, the CPE is configured to describe capacitive characteristics of a complex system, especially when conventional capacitor models cannot accurately describe a non-ideal interface behavior. The CPE value is related to the roughness and uniformity of the interface, as well as the interaction between the electrode materials and the electrolyte or binder.

The first constant phase element value (CPEs) is involved, which reflects the interfacial characteristics between the binder and the solvent, describing a complex capacitive behavior when the binder and the solvent are in contact, including charge distribution, adsorption, and desorption processes.

The second constant phase element value (CPEp) is involved, simulates the interfacial characteristics between the binder and the active material, particularly the contact efficiency between an active material particle surface and the binder, which directly affects the mechanical strength of the electrode and the formation of an electronic conductive network.

The third constant phase element value (CPEdl) is involved, which represents the interfacial characteristics between the conductive agent and the active material, including the coverage of the conductive agent on an active material surface, the formation of the conductive network, and the charge transport efficiency between the conductive agent and the active material.

Through the steps provided in this embodiment, based on the fitted CPE values, the contact performance between materials within the electrode slurry may also be evaluated in a layered manner. By combining the first sub-contact performance, the second sub-contact performance, and the third sub-contact performance, the internal contact performance of the electrode slurry may be comprehensively evaluated, namely, the interactions and contact states between components, so as to better determine the performance parameters of the cell. This information plays a key role in understanding an internal structure and electrochemical processes of the battery, and further optimizing the slurry formulation and battery performance.

As an optional embodiment, the step of determining test data corresponding to the target slurry under test parameters includes: transferring the target slurry into a predetermined test fixture, where the predetermined test fixture includes a target test tube, a first conductive electrode, and a second conductive electrode, the first conductive electrode is located on a first side surface of the target test tube, and the second conductive electrode is located on a second side surface of the target test tube; and activating the predetermined test fixture under the test parameters to obtain the test data.

In this embodiment, the step of obtaining the test data is described.

The predetermined test fixture is involved. The predetermined test fixture is an apparatus specially designed and prepared for electrochemical impedance spectroscopy testing, includes key components such as the target test tube, the first conductive electrode, and the second conductive electrode, and is configured to precisely control a slurry state under test conditions.

The target test tube is involved. The target test tube is configured to hold the slurry. The target test tube may be a visualizable test tube. The visualizable test tube is a transparent or semitransparent container that allows an observer to see the state of the internal slurry directly or through an imaging device, including distribution, contact, and reaction conditions, which facilitates control over the uniformity and content of the slurry.

The first conductive electrode and the second conductive electrode are involved. The electrodes in the test fixture are designed to contact the slurry and transfer the current, thereby acquiring electrochemical impedance data. These electrodes are typically made of good conductive materials, such as copper, aluminum, or gold.

In this way, in order to acquire electrochemical impedance test data of the target slurry under specific conditions, the slurry is first transferred into the predetermined test fixture. The fixture includes the target test tube, as well as the first conductive electrode and the second conductive electrode located on both sides of the test tube, and meanwhile facilitates the fixation of the test tube. In a case where the target test tube is the visualizable test tube, the visualizable design allows a researcher to directly observe the distribution of the slurry between the electrodes, which helps ensure the uniformity and controllable content of the slurry. Then, the test fixture is activated under the set test parameters (e.g., temperature and frequency range), and the slurry is subjected to impedance measurement by an electrochemical impedance test system. A final result of this series of operations is a set of test data containing impedance characteristics of the slurry in different electrochemical processes, such as charge transfer, solution resistance, active material resistance, and double layer resistance.

The design of the test fixture can ensure that the slurry maintains structural stability and consistency during the test, which is critical for the accuracy and repeatability of impedance testing. The fixture can provide a standardized environment to ensure consistency of key parameters such as slurry thickness, contact area, and pressure in each test, thereby reducing the variability of test results and improving data reliability. The conductive electrodes on both sides of the test fixture can ensure precise contact with the slurry. Good electrical contact is a prerequisite for acquiring accurate impedance data. If the contact between the electrodes and the slurry is poor, impedance values in the test results may be high, affecting the accurate evaluation of the electrochemical performance of the slurry. The test fixture can enable testing within a specific temperature range, which helps evaluate the impedance performance of the slurry under different temperature conditions, thereby better understanding the behavior of the slurry in the actual battery operating environment.

As an optional embodiment, a frequency band of an alternating current test current corresponding to the second sub-circuit is greater than a frequency band of an alternating current test current corresponding to the third sub-circuit, and the frequency band of the alternating current test current corresponding to the third sub-circuit is greater than a frequency band of an alternating current test current corresponding to the fourth sub-circuit.

In this embodiment, the frequency band of the alternating current test current is involved. In electrochemical impedance spectroscopy (EIS) testing, alternating current (AC) signals are used. AC signals at different frequency bands can probe an electrochemical response of a sample (e.g., electrode slurry) on different time scales. A high-frequency signal (e.g., MHz range) is typically associated with fast electrochemical processes such as solution resistance, while a low-frequency signal (e.g., Hz range) is associated with slow electrochemical processes such as charge transfer and diffusion.

In electrochemical impedance spectroscopy testing, alternating current test currents at different frequency bands respectively correspond to different sub-circuits in the equivalent circuit model. The frequency band of the alternating current test current corresponding to the second sub-circuit being higher than that of the third sub-circuit means that the second sub-circuit primarily reflects a faster electrochemical process inside the electrode slurry, while the third sub-circuit corresponds to a slow electrochemical process. Similarly, the frequency band of the third sub-circuit being higher than that of the fourth sub-circuit indicates that the fourth sub-circuit simulates the slowest electrochemical process. A correspondence between the frequency bands and the sub-circuits helps distinguish and identify time scales of the electrochemical processes, thereby more accurately analyzing an electrochemical mechanism in the slurry.

The fast, medium-speed, and slow electrochemical processes within the slurry can be distinguished through the alternating current test currents at different frequency bands. This correspondence enables more accurate allocation and optimization of the circuit parameters, such as resistance values and capacitance values during electrochemical impedance spectrum fitting, so as to reflect characteristics of different electrochemical processes.

Processes in an electrochemical system often have different kinetic speeds. The fast process (e.g., solution resistance) is typically manifested in a high-frequency band, while the slow process (e.g., charge transfer resistance or diffusion process) is more prominent in a low-frequency band. By associating each element of an equivalent circuit with a specific frequency range, impedance contributions of different processes in the electrochemical system may be analyzed one by one, thereby obtaining a deeper mechanistic understanding. This is because impedance characteristics of different elements vary at different frequencies. For example, capacitive elements exhibit significant capacitive characteristics at high frequencies, while in the low-frequency band, the capacitive elements may be masked by characteristics of other impedance elements. Therefore, dividing the circuit into a plurality of orders, with each order optimized and fitted for a specific frequency range, can improve the accuracy and reliability of the overall impedance spectrum fitting, ensuring that each electrochemical process is accurately reflected. By distinguishing these frequency bands, various physical and chemical parameters in the electrochemical system may be more clearly identified and quantified. Understanding frequency responses of different electrochemical processes helps optimize the performance of the battery materials.

As an optional embodiment, after the step of predicting, based on the plurality of circuit parameter values, performance parameters of the cell fabricated using the target slurry under the test parameters, the method further includes: determining composition parameters of the target slurry in a case where the performance parameters are less than a predetermined threshold; and adjusting the composition parameters to obtain an updated slurry, so as to determine performance parameters corresponding to the updated slurry.

In this embodiment, the process of obtaining the updated slurry to determine the performance parameters corresponding to the updated slurry is described.

The predetermined threshold is involved. The predetermined threshold refers to a minimum or maximum allowable value for a series of parameters set in a battery design stage to achieve expected battery performance. For example, to meet application requirements of the electric vehicles, an energy density threshold of the cell may be set above a specific value.

The composition parameters are involved. The composition parameters refer to a material composition and ratios in the electrode slurry, such as the types and contents of the active material, the conductive agent, the binder, and the solvent.

The updated slurry is involved. The updated slurry is a slurry re-prepared after adjusting the composition parameters according to the comparison between a performance prediction result and the predetermined threshold.

After the performance parameters of the cell fabricated using the target slurry are predicted based on the electrochemical impedance spectroscopy test data, if these performance parameters fail to meet or fall below the predetermined threshold set in advance, the circuit parameter values need to be further analyzed to determine which composition parameters (e.g., material types, contents, or ratios) need to be adjusted. By purposefully changing the composition parameters of the slurry, the updated slurry is prepared, and electrochemical impedance spectroscopy testing is performed again. Based on the new test data, the performance parameters of the cell are re-predicted until the performance parameters meet or exceed the predetermined threshold. This process may require a plurality of iterations until an optimal slurry formulation is found. Through a feedback loop of electrochemical impedance spectroscopy testing and performance parameter prediction, the slurry formulation optimization process can be accelerated, avoiding the time consumption and resource waste of conventional test methods. Based on the analysis of the circuit parameter values, the composition parameters of the slurry can be more precisely adjusted to achieve refined control over the battery performance.

As an optional embodiment, before the step of inputting the impedance test data into an equivalent circuit model for fitting to obtain a plurality of circuit parameter values, the method further includes: acquiring a sample slurry and a sample battery constructed from the sample slurry, where the sample battery is the target type of battery; determining sample performance parameters of the sample battery; determining a correlation between a composition of the sample slurry and the sample performance parameters; and constructing the equivalent circuit model based on the correlation.

In this embodiment, the process of constructing the equivalent circuit is described.

The sample slurry is involved. The sample slurry is a slurry with a specific formulation, used for the preparation of battery electrodes. Composition components and ratios of the sample slurry reflect the preliminary or optimized selection of electrode materials in the battery design.

The sample battery is involved. The sample battery is a cell fabricated from the sample slurry in accordance with a target type of battery structure and process requirements, which is configured to evaluate the performance of the specific slurry formulation in an actual battery.

The sample performance parameters are involved. The sample performance parameters are performance indicators exhibited by the sample battery under various test conditions (e.g., charge-discharge cycle, temperature, or current), including an energy density, a power density, a cycle life, impedance characteristics, and the like.

The correlation is involved. The correlation is an experimentally derived relationship between the composition components of the sample slurry and the sample battery performance parameters. This relationship may be used to guide the construction and parameter fitting of the equivalent circuit model.

In the battery research and development process, the sample slurry is first prepared, and the sample battery is fabricated according to the target battery type and requirements. Next, through a series of performance tests, the performance parameters of the sample battery are determined, such as the energy density and charge-discharge efficiency. Then, based on the correlation between the composition components of the slurry (e.g., the types and ratios of the active material, the conductive agent, the binder, and the solvent) and the measured performance parameters, the influence of each component on the battery performance can be deeply understood. Finally, the equivalent circuit model for electrochemical impedance spectroscopy is constructed or optimized according to these correlations, to more accurately simulate the internal electrochemical processes of the battery and the electrochemical characteristics of the slurry.

In this way, through the analysis of the correlation, which slurry components have a significant impact on the battery performance may be clarified, thereby enabling targeted adjustment of the slurry formulation to optimize the battery performance. The construction and fitting of the equivalent circuit model enable the researcher to gain in-depth understanding of the internal electrochemical processes of the battery, including ion migration, charge transfer, diffusion, and the like., providing a theoretical basis for battery design. Based on the feedback from the sample performance parameters, unnecessary use of slurry components or process tests can be reduced, lowering research and development costs and time consumption.

Based on the foregoing embodiments and the optional embodiments, an optional implementation is provided, and is specifically described below.

The optional implementation in the present disclosure provides a method for testing and analyzing an impedance of a lithium-ion battery electrode slurry and an application of the method, as well as a system for analyzing an internal conductive network of a lithium-ion cathode slurry, including the method for testing and analyzing an impedance of a lithium-ion battery electrode slurry and a test fixture.
(1) Method for testing impedance of lithium-ion battery electrode slurry:
   S1: A main material, a binder, a conductive agent, a dispersant, and a functional additive are mixed with a solvent at ratios of 50% to 100%, 0% to 20%, 0% to 20%, 0% to 10%, and 0% to 10% respectively, but not limited to these ratio ranges, to prepare a mixed slurry, with the total ratio being 100%.

As at least one alternative embodiment, the main material, the binder, the conductive agent, the dispersant, and the functional additive may also be mixed with the solvent at ratios of 50% to 100%, 0% to 20%, 0% to 20%, 0% to 10%, and 0% to 10% respectively, but not limited to these ranges, to prepare a mixed slurry, with the total ratio being 100%.

S2: The mixed slurry is transfered into a designed test fixture.

S3: A slurry impedance is measured using an electrochemical impedance test system.

Lithium-ion cathode slurry samples with different ratios of conductive agent contents are prepared, the novel test fixture is used to conduct conductivity tests on the slurry samples, the conductivity performance of the slurry under different conductive agent contents is analyzed, a structure and connectivity of the internal conductive network of the slurry are evaluated according to the corresponding equivalent circuit, and an optimal cathode conductive agent material and an optimal conductive agent content are screened out according to an analysis result.

For example, a fitting method includes: performing an electrification test on the conductive slurry to obtain impedance test data of the conductive slurry; using impedance analysis software to fit and obtain initial element impedance values in the electrochemical impedance testing equivalent circuit based on the impedance test data; and using the impedance analysis software to fit and obtain an electrochemical impedance spectrum of the conductive slurry based on the initial element impedance values.

As at least one alternative embodiment, in step S3, the electrochemical impedance test system includes a first-order equivalent circuit, a second-order equivalent circuit, and a third-order equivalent circuit which are sequentially connected in series, where the first-order equivalent circuit is connected in series with the charge transfer resistance. The impedance analysis software fits and obtains the initial element impedance values in the electrochemical impedance testing equivalent circuit based on the impedance test data, and fits and obtains the electrochemical impedance spectrum of the conductive slurry.

As at least one alternative embodiment, in steps S1, S2, and S3, slurry preparation and impedance testing may be performed at -20°C to 100°C.

As at least one alternative embodiment, in step S3, a frequency range of the impedance test is 0.01 Hz to 8 MHz.

As at least one alternative embodiment, in step S3, a disturbance voltage range of the impedance test is 10 mV to 1 V.

As at least one alternative embodiment, the solvent includes, but is not limited to, N-methylpyrrolidone, water, ethanol, isopropanol, or another lithium battery solvent.

As at least one alternative embodiment, a solid content of the mixed slurry is 10% to 100%, where the solid content represents the content of solid substances.

As at least one alternative embodiment, the conductive agent (conductive slurry) includes any one or a combination of at least two of conductive carbon black, a carbon nanotube, a carbon nanorod, a carbon fiber, or graphene.

As at least one alternative embodiment, the main material includes any one or a combination of at least two of lithium cobalt oxide, lithium manganese oxide, lithium nickel manganese cobalt oxide, lithium iron phosphate, lithium manganese iron phosphate, lithium nickel cobalt aluminum oxide, lithium titanate, graphite, or silicon.

As at least one alternative embodiment, the binder includes any one or a combination of at least two of polytetrafluoroethylene (PTFE), polyvinylidene fluoride (PVDF), carboxymethyl cellulose (CMC), styrene-butadiene rubber (SBR), polyacrylic acid (PAA), polyacrylonitrile (PAN), polyimide (PI), perfluorosulfonic acid ionomer (Nafion), a natural extract binder, a conductive binder, a self-healing binder, or a thermoplastic polymer.

As at least one alternative embodiment, the dispersant includes oil-based dispersant or a water-based dispersant.

As at least one alternative embodiment, other types of functional additives include a wetting agent, a thickener, an anti-cracking agent, and the like, where the wetting agent is a functional additive used to reduce slurry viscosity and promote the formation of a stable slurry suspension, and he thickener is a functional additive used to increase the slurry viscosity and improve the slurry stability. The anti-cracking agent is a functional additive used to prevent a cracking phenomenon during a slurry coating process.

### (2) Test fixture:

Fig. 2 is a schematic diagram of a test fixture according to an optional implementation of the present disclosure. As shown in Fig. 2, the text fixture includes electrodes on both sides and a content-visualization test tube, for performing conductivity testing on the lithium-ion cathode slurry samples. A test jig with a specific structure and function, test instruments, and a three-order equivalent circuit fitting method for electrochemical impedance spectroscopy are included.

As at least one alternative embodiment, the test fixture includes the electrodes on both sides and the content-visualization test tube.

As at least one alternative embodiment, the electrodes on both sides of the test fixture include at least one metal selected from iron (Fe), copper (Cu), gold (Au), silver (Ag), aluminum (Al), cobalt (Co), chromium (Cr), manganese (Mn), molybdenum (Mo), titanium (Ti), zirconium (Zr), tin (Sn), vanadium (V), niobium (Nb), Tantalum (Ta), hafnium (Hf), or combinations of these metals.

As at least one alternative embodiment, a material of the content-visualization test tube of the test fixture includes, but is not limited to, polyvinyl chloride (PVC), unplasticized polyvinyl chloride (UPVC), polypropylene (PP), polyethylene (PE), polypropylene random copolymer (PPR), cross-linked polyethylene (PEX), glass, a mica sheet, an inorganic ceramic material, and the like.

### (3) Three-order equivalent circuit for electrochemical impedance spectroscopy:

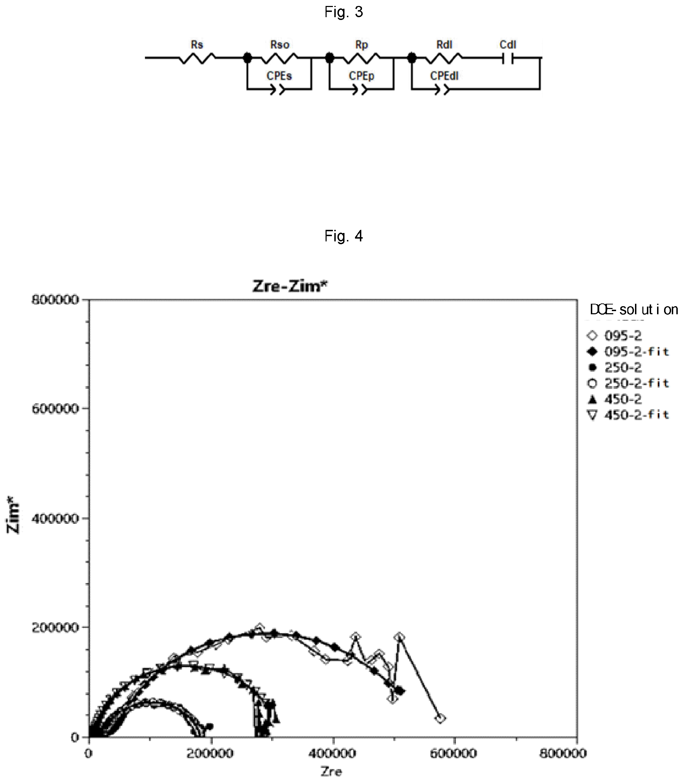

Fig. 3 is a schematic diagram of an internal slurry impedance fitting circuit according to an optional implementation of the present disclosure. As shown in Fig. 3, a conductive slurry equivalent circuit model is constructed based on the chemical component analysis of an electrode slurry. The three-order equivalent circuit includes a first-order equivalent circuit, a second-order equivalent circuit, and a third-order equivalent circuit which are sequentially connected in series, where the first-order equivalent circuit is connected in series with a charge transfer resistance. A frequency band of an alternating current test current corresponding to the first-order equivalent circuit is greater than a frequency band of an alternating current test current corresponding to the second-order equivalent circuit, and the frequency band of the alternating current test current corresponding to the second-order equivalent circuit is greater than a frequency band of an alternating current test current corresponding to the third-order equivalent circuit.

Rso represents a solution resistance, Rp represents a transmission path resistance, Rdl represents a double layer resistance between the conductive agent and the main material, CPE (not shown in the figure, used to introduce CPEs) is an element for fitting a non-ideal capacitor behavior in the impedance spectrum, which can describe phase change characteristics of dielectric materials at different frequencies, because a capacitance of real materials typically does not exhibit an ideal 90-degree phase shift of an ideal capacitor across all frequencies. CPEs is a constant phase element for describing an interface between the binder and the solvent, which describes the capacitive behavior at a solution-solute contact interface, and helps understand the interaction and dispersion state between a solution and a solute. CPEp typically represents a constant phase element at a connection interface between the binder and the main material (e.g., the active material of the lithium-ion battery), reflecting surface electrochemical characteristics of the active material and the formation of the double layer. CPEdl represents a constant phase element at an interface between the conductive agent and the main material, describing a capacitive behavior at a contact interface between the conductive agent and the active material, which helps to understand the interaction and dispersion state between the conductive agent and the active material. Cdl typically refers to a "double layer capacitance", which is an important parameter in the electrochemical system. In electrochemical impedance spectroscopy (EIS) analysis, Cdl is a measure of a capacitive nature of a double-layer structure formed at an electrochemical interface (typically an electrode/electrolyte interface). When ions in the electrolyte come into contact with a charged electrode surface, a double layer composed of an electrode surface charge and counteracting electrolyte ions may be formed. The formation and variation of this double layer have a significant impact on a rate and efficiency of electrochemical reactions.

As an optional implementation, the material of the content-visualization test tube in the test fixture includes, but is not limited to, PVC, UPVC, PP, PE, PPR, PEX, glass, a mica sheet, an inorganic ceramic materials, and the like. In the following embodiments, taking an example that lithium manganese iron phosphate is used as the main material, conductive carbon black SP is used as the conductive agent, a copper wire is used as a fixture electrode, and PVC is used as the test tube material, the designed three-order equivalent circuit for electrochemical impedance spectroscopy is adopted, with a perturbation voltage of 10 mV and a measurement frequency range of 0.01 Hz to 1 MHz, to provide a more detailed description of the application of the method for testing and analyzing an impedance of a lithium-ion battery electrode slurry.

Fig. 4 is a comparison diagram of slurry impedance data under different conductive agent contents according to an optional implementation of the present disclosure. Test results are shown in Fig. 4. 095-2 represents Method 1, 250-2 represents Method 2, and 450-2 represents Method 3, where "fit" represents a curve fitted using ZView software combined with the three-order equivalent circuit. The fit curve is close to an original actual curve, for demonstrating the accuracy of the three-order equivalent circuit. The difference among the three methods lies in the variation of the content of the conductive agent. All other formulations remain unchanged, and 095 represents 0.95% conductive agent.
1) Method 1:
   An appropriate amount of PVDF and N-methylpyrrolidone (NMP) are added to a vacuum mixer and stirred to prepare a gel solution for later use. 0.95% conductive slurry (calculated based on the content of the conductive agent SP) is added to a homogenization tank, and then the gel solution containing 1.5% PVDF is added. Stirring is performed at 850 rpm for 10 min by using a homogenizer. Then, 97.55% lithium manganese iron phosphate is slowly added, and stirring is performed at 850 rpm for 10 min by using the homogenizer to prepare a mixed slurry with a total weight of 80 g and a total solid content of approximately 50%. After stirring, the mixed slurry is transferred to the text fixture and tested by an impedance tester. The test results are shown in Fig. 4.
2) Method 2:
   An appropriate amount of PVDF and NMP are added to the vacuum mixer and stirred to prepare a gel solution for later use. 2.5% conductive slurry (calculated based on the content of the conductive agent SP) is added to the homogenization tank, and then the gel solution containing 1.5% PVDF is added. Stirring is performed at 850 rpm for 10 min by using the homogenizer. Then, 96% lithium manganese iron phosphate is slowly added, and stirring is performed at 850 rpm for 10 min by using the homogenizer to prepare a mixed slurry with a total weight of 80 g and a total solid content of approximately 50%. After stirring, the mixed slurry is transferred to the text fixture and tested by the impedance tester. The test results are shown in Fig. 4.
3) Method 3:
   An appropriate amount of PVDF and NMP are added to the vacuum mixer and stirred to prepare a gel solution for later use. 4.5% conductive slurry (calculated based on the content of the conductive agent SP) is added to the homogenization tank, and then the gel solution containing 1.5% PVDF is added. Stirring is performed at 850 rpm for 10 min by using the homogenizer. Then, 94% lithium manganese iron phosphate is slowly added, and stirring is performed at 850 rpm for 10 min by using the homogenizer to prepare a mixed slurry with a total weight of 80 g and a total solid content of approximately 50%. After stirring, the mixed slurry is transferred to the text fixture and tested by the impedance tester. The test results are shown in Fig. 4.

The test results from Methods 1 to 3 are imported into the impedance analysis software, and the three-order equivalent circuit for electrochemical impedance spectroscopy is used for fitting, and the following conclusions are drawn.

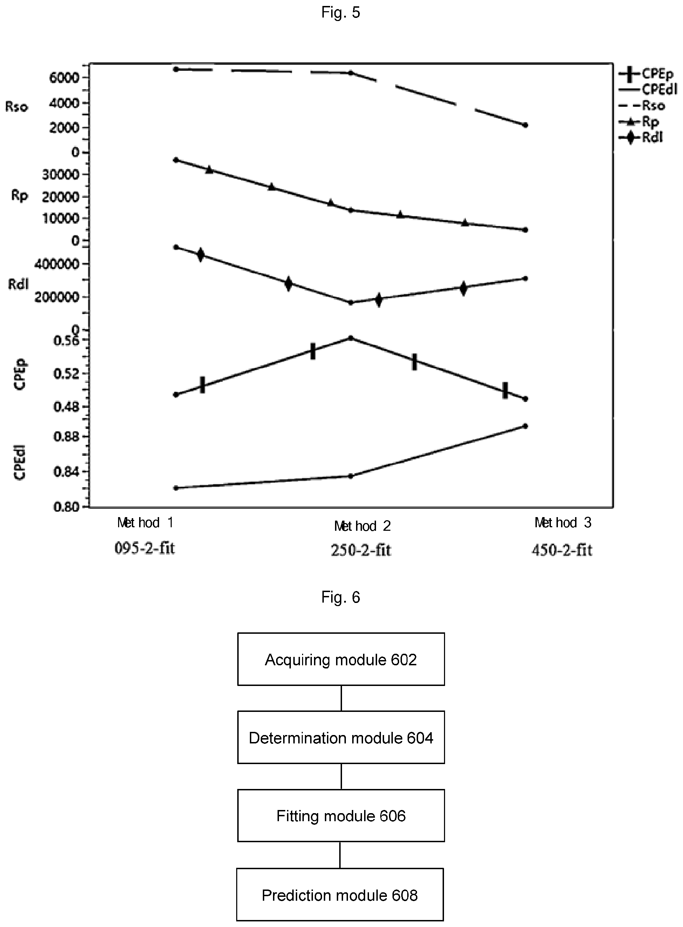

Conclusions: Fig. 5 illustrates fitting data of an internal impedance of a slurry according to an optional implementation of the present disclosure. As shown in Fig. 4 and Fig. 5, curves 095-2-fit, 250-2-fit, and 450-2-fit fitted by the designed fitting circuit are very close to the actual curve, indicating that the equivalent circuit accurately presents a state of the internal conductive network of the slurry. Further, with the increase of the SP content in the conductive slurry, the solution resistance Rso and the transmission path resistance Rp decrease significantly, that is, the increase of the conductive agent improves the conductivity of the electrode slurry and reduces the resistance. The double layer resistance Rdl between the conductive agent and the main material first decreases and then increases, indicating a dispersion state between the conductive agent and the main material. The data of CPEp and CPEdl further illustrates a dispersion state among the conductive agent, the main material and the PVDF binder.

Through the foregoing optional implementations, at least the following beneficial effects may be achieved:
(1) The optional implementation of the present disclosure provides the fixture that can be directly used for testing the slurry impedance. The visualized content can be used to control the slurry content, and the fixed fixture and unified variables make data results more accurate and reduce random errors; and test electrodes on both sides facilitate the mixing and transferring of the slurry.
(2) The optional implementation of the present disclosure provides the electrochemical impedance test system and the analysis method constructed based on the chemical component analysis in the electrode slurry, which may accurately and quickly obtain the method for the composition of the internal conductive network of the slurry, can quickly and accurately reveal the state of the internal conductive network of the slurry, and can be used to screen cathode conductive agent materials.
(3) The optional implementation of the present disclosure provides the method for quickly screening the type and the content of the conductive agent, as well as the type and the content of the main material, namely, a method for evaluating and screening slurries with different conductive agent contents by using the foregoing analysis system. The problems of the tedious and inefficient screening work of electrode slurry formulations are solved, and a purpose of quickly and accurately evaluating the internal conductive network of slurries under different formulations is implemented. The internal conductive network structure of the electrode slurry may be more comprehensively understood, and an important reference is provided for the design and optimization of lithium-ion electrode materials, thereby optimizing the battery performance.

It should be noted that for ease of description, the foregoing method embodiments are all described as a series of action combinations. However, those skilled in the art should understand that the present disclosure is not limited to the described action order, as some steps may be performed in another order or simultaneously according to the present disclosure. In addition, those skilled in the art should also understand that all the embodiments described in the specification are preferred embodiments, and the involved actions and modules are not necessary to the present disclosure.

According to the descriptions of the foregoing implementations, those skilled in the art may clearly know that the method according to the foregoing embodiments may be implemented by software and a necessary general-purpose hardware platform, and certainly, may also be implemented by hardware, but the former is a preferred implementation in many cases. Based on such an understanding, the technical solution of the present disclosure essentially or parts making contribution to the prior art may be embodied in the form of a software product. The computer software product is stored in a storage medium (e.g., a ROM/RAM, a magnetic disk, or a compact disc), which includes a plurality of instructions configured for allowing one terminal device (which may be a mobile phone, a computer, a server, a network device, or the like) to perform the method according to various embodiments of the present disclosure.

### Embodiment 2

According to this embodiment of the present disclosure, an apparatus configured to implement the foregoing method for predicting performance parameters of a cell is further provided. Fig. 6 is a structural block diagram of an apparatus for predicting performance parameters of a cell according to an embodiment of the present disclosure. As shown in Fig. 6, the apparatus includes: an acquiring module 602, a determination module 604, a fitting module 606, and a prediction module 608, and the apparatus is described in detail below.

The acquiring module 602 is configured to acquire a target slurry, where the target slurry is configured to construct a target type of cell; the determination module 604 is connected to the acquiring module 602, and is configured to determine test data corresponding to the target slurry under test parameters, where the test data includes impedance test data; the fitting module 606 is connected to the determining module 604, and is configured to input the impedance test data into an equivalent circuit model for fitting to obtain a plurality of circuit parameter values, where the equivalent circuit model is constructed based on the target type of cell, the equivalent circuit model includes four sub-circuits, a first sub-circuit includes a charge transfer resistance, a second sub-circuit is formed by a solution resistance connected in parallel with a first constant phase element, a third sub-circuit is formed by an active material resistance connected in parallel with a second constant phase element, a fourth sub-circuit is formed by a double layer resistance-capacitance connected in parallel with a third constant phase element, the first constant phase element is a constant phase element representing interfacial characteristics between a binder and a solvent, the second constant phase element is a constant phase element representing interfacial characteristics between the binder and an active material, the third constant phase element is a constant phase element representing interfacial characteristics between a conductive agent and the active material, the double layer resistance-capacitance is obtained by connecting a double layer resistance and a double layer capacitance in series, and the four sub-circuits are connected in series sequentially; and the prediction module 608 is connected to the fitting module 606, and is configured to predict, based on the plurality of circuit parameter values, performance parameters of the cell fabricated using the target slurry under the test parameters.

It should be noted that the acquiring module 602, the determination module 604, the fitting module 606, and the prediction module 608 correspond to step S102 to step S108 in the method for predicting performance parameters of a cell. The examples and application scenarios implemented by the plurality of modules and the corresponding steps are the same, but are not limited to the content disclosed in Embodiment 1.

### Embodiment 3

According to another aspect of this embodiment of the present disclosure, an electronic device is further provided, and includes a processor; and a memory configured to store instructions executable by the processor, where the processor is configured to execute the instructions to implement any one of the foregoing methods for predicting cell performance parameters.

### Embodiment 4

According to another aspect of this embodiment of the present disclosure, a computer-readable storage medium is further provided. Instructions in the computer-readable storage medium, when executed by a processor of an electronic device, cause the electronic device to perform any one of the foregoing methods for predicting cell performance parameters.

The serial numbers of the foregoing embodiments of the present disclosure are for descriptive purposes only and do not represent the superiority or inferiority of the embodiments.

In the foregoing embodiments of the present disclosure, the embodiments are described with respective focuses. For a part that is not described in detail in a certain embodiment, reference may be made to related descriptions in other embodiments.

In the several embodiments provided in this application, it should be understood that the disclosed technical content may be implemented in other manners. The apparatus embodiments described above are merely illustrative, such as the unit division which may be a logical function division, and during practical implementation, there may be additional division methods. For example, a plurality of units or components may be combined or integrated into another system, or some features may be ignored or not executed. In addition, the shown or discussed mutual coupling or direct coupling, or communication connection may be an indirect coupling or communication connection through some interfaces, units, or modules, or may be in an electrical form or other forms.

The units described as separate components may or may not be physically separated, and components displayed as units may or may not be physical units, that is, may be located in one position, or may be distributed over a plurality of units. Some or all of the units may be selected according to actual needs to achieve the objectives of the solutions of the embodiments.

In addition, various functional units in the embodiments of the present disclosure may be integrated into one processing unit, each of the units may exist alone physically, or two or more units may be integrated into one unit. The foregoing integrated unit may be implemented in the form of hardware or a software functional unit.

If the integrated unit is implemented in the form of the software functional unit and sold or used as an independent product, the integrated unit may be stored in a computer-readable storage medium. Based on such an understanding, the technical solutions of the present disclosure essentially or parts making contribution to the prior art or all or part of the technical solutions may be embodied in the form of a software product. The computer software product is stored in a storage medium and includes a plurality of instructions to allow a computer device (which may be a personal computer, a server, a network device, or the like) to perform all or part of the steps of the methods according to the embodiments of the present disclosure. The foregoing storage medium includes a U disk, a read-only memory (ROM), a random access memory (RAM), a mobile hard drive, a magnetic disk, an optical disk, or other media capable of storing program code.

The foregoing contents are merely preferred implementations of the present disclosure. It should be noted that a plurality of improvements and modifications may also be made by those of ordinary skill in the art without departing from the principle of the present disclosure, and these improvements and modifications should be regarded as within the scope of protection of the present disclosure.

### Industrial applicability

The solutions provided by the embodiments of this application may be applied to the battery field. In the embodiments of this application, the target slurry is acquired, where the target slurry is configured to construct the target type of cell; the test data corresponding to the target slurry under the test parameters is determined, where the test data includes the impedance test data; the impedance test data is inputted into the equivalent circuit model for fitting to obtain the plurality of circuit parameter values, where the equivalent circuit model is constructed based on the target type of cell; and based on the plurality of circuit parameter values, the performance parameters of the cell fabricated using the target slurry under the test parameters are predicted. This implementation solves the technical problem in the related art where it is difficult to conveniently determine cell-related performance parameters from the slurry, achieves a purpose of rapidly and accurately revealing the internal electrochemical characteristics of the slurry, and thus achieves a technical effect of improving the high efficiency and accuracy of determining the cell-related performance parameters from the slurry.

## Claims

1. A method for predicting performance parameters of a cell, comprising:
acquiring a target slurry, wherein the target slurry is configured to construct a target type of cell;
determining test data corresponding to the target slurry under test parameters, wherein the test data comprises impedance test data;
inputting the impedance test data into an equivalent circuit model for fitting to obtain a plurality of circuit parameter values, wherein the equivalent circuit model is constructed based on the target type of cell, the equivalent circuit model comprises four sub-circuits, a first sub-circuit comprises a charge transfer resistance, a second sub-circuit is formed by a solution resistance connected in parallel with a first constant phase element, a third sub-circuit is formed by an active material resistance connected in parallel with a second constant phase element, a fourth sub-circuit is formed by a double layer resistance-capacitance connected in parallel with a third constant phase element, the first constant phase element is a constant phase element representing interfacial characteristics between a binder and a solvent, the second constant phase element is a constant phase element representing interfacial characteristics between the binder and an active material, the third constant phase element is a constant phase element representing interfacial characteristics between a conductive agent and the active material, the double layer resistance-capacitance is obtained by connecting a double layer resistance and a double layer capacitance in series, and the four sub-circuits are connected in series sequentially; and
predicting, based on the plurality of circuit parameter values, performance parameters of the cell fabricated using the target slurry under the test parameters.

2. The method as claimed in claim 1, wherein the predicting, based on the plurality of circuit parameter values, performance parameters of the cell fabricated using the target slurry under the test parameters comprises:
determining charge transfer efficiency performance between the solvent and an electrode material based on a fitted charge transfer resistance value in a case where the target slurry comprises the electrode material, a conductive agent, and the solvent, the electrode material comprises an active material, and the plurality of circuit parameter values comprise a fitted charge transfer resistance value, a fitted solution resistance value, a fitted active material resistance value, a fitted double layer resistance value, and a fitted constant phase element value;
determining, based on the fitted solution resistance value, a conductive path impedance formed by the binder and a conductive material;
determining, based on the fitted active material resistance value, an active material impedance of the active material within the electrode material;
determining, based on the fitted double layer resistance value, charge transport performance between the conductive agent and the active material;
determining, based on the fitted constant phase element value, dispersion performance of each component within the target slurry; and
predicting the performance parameters of the cell fabricated using the target slurry under the test parameters based on the charge transfer efficiency performance, the conductive path impedance, the active material impedance, the charge transport performance, and the dispersion performance.

3. The method as claimed in claim 2, wherein the predicting the performance parameters of the cell fabricated using the target slurry under the test parameters based on the charge transfer efficiency performance, the conductive path impedance, the active material impedance, the charge transport performance, and the dispersion performance comprises:
determining first sub-contact performance between the binder and the solvent based on a first constant phase element value in a case where the electrode material further comprises the binder, and the fitted constant phase element value comprises a first constant phase element value, a second constant phase element value, and a third constant phase element value;
determining second sub-contact performance between the binder and the active material based on the second constant phase element value;
determining third sub-contact performance between the conductive agent and the active material based on the third constant phase element value;
determining contact performance corresponding to the electrode material based on the first sub-contact performance, the second sub-contact performance, and the third sub-contact performance; and
predicting the performance parameters of the cell fabricated using the target slurry under the test parameters based on the charge transfer efficiency performance, the conductive path impedance, the active material impedance, the charge transport performance, the dispersion performance, and the contact performance.

4. The method as claimed in claim 1, wherein the determining test data corresponding to the target slurry under test parameters comprises:
transferring the target slurry into a predetermined test fixture, wherein the predetermined test fixture comprises a target test tube, a first conductive electrode, and a second conductive electrode, the first conductive electrode is located on a first side surface of the target test tube, and the second conductive electrode is located on a second side surface of the target test tube; and
activating the predetermined test fixture under the test parameters to obtain the test data.

5. The method as claimed in claim 1, wherein a frequency band of an alternating current test current corresponding to the second sub-circuit is greater than a frequency band of an alternating current test current corresponding to the third sub-circuit, and the frequency band of the alternating current test current corresponding to the third sub-circuit is greater than a frequency band of an alternating current test current corresponding to the fourth sub-circuit.

6. The method as claimed in claim 1, wherein after the predicting, based on the plurality of circuit parameter values, performance parameters of the cell fabricated using the target slurry under the test parameters, the method further comprises:
determining composition parameters of the target slurry in a case where the performance parameters are less than a predetermined threshold; and
adjusting the composition parameters to obtain an updated slurry, so as to determine performance parameters corresponding to the updated slurry.

7. The method as claimed in any one of claims 1 to 6, wherein before the inputting the impedance test data into an equivalent circuit model for fitting to obtain a plurality of circuit parameter values, the method further comprises:
acquiring a sample slurry and a sample battery constructed from the sample slurry, wherein the sample battery is the target type of battery;
determining sample performance parameters of the sample battery;
determining a correlation between a composition of the sample slurry and the sample performance parameters; and
constructing the equivalent circuit model based on the correlation.

8. An apparatus for predicting performance parameters of a cell, comprising:
an acquiring module, configured to acquire a target slurry, wherein the target slurry is configured to construct a target type of cell;
a determination module, configured to determine test data corresponding to the target slurry under test parameters, wherein the test data comprises impedance test data;
a fitting module, configured to input the impedance test data into an equivalent circuit model for fitting to obtain a plurality of circuit parameter values, wherein the equivalent circuit model is constructed based on the target type of cell, the equivalent circuit model comprises four sub-circuits, a first sub-circuit comprises a charge transfer resistance, a second sub-circuit is formed by a solution resistance connected in parallel with a first constant phase element, a third sub-circuit is formed by an active material resistance connected in parallel with a second constant phase element, a fourth sub-circuit is formed by a double layer resistance-capacitance connected in parallel with a third constant phase element, the first constant phase element is a constant phase element representing interfacial characteristics between a binder and a solvent, the second constant phase element is a constant phase element representing interfacial characteristics between the binder and an active material, the third constant phase element is a constant phase element representing interfacial characteristics between a conductive agent and the active material, the double layer resistance-capacitance is obtained by connecting a double layer resistance and a double layer capacitance in series, and the four sub-circuits are connected in series sequentially; and
a prediction module, configured to predict, based on the plurality of circuit parameter values, performance parameters of the cell fabricated using the target slurry under the test parameters.

9. An electronic device, comprising:
a processor; and
a memory configured to store instructions executable by the processor,
wherein the processor is configured to execute the instructions, to implement the method for predicting performance parameters of a cell as claimed in any one of claims 1 to 7.

10. A computer-readable storage medium, instructions in the computer-readable storage medium, when executed by a processor of an electronic device, causing the electronic device to perform the method for predicting performance parameters of a cell as claimed in any one of claims 1 to 7.
